# EUROPEAN PATENT APPLICATION

(11) **EP 4 766 139 A1**
(43) Date of publication of application: **24.06.2026**
(21) Application number: 25219431.1
(22) Date of filing: 28.11.2025
(51) Int. Cl.: H10W 70/05, H10W 70/60, H10W 70/63, H10W 70/652, H10W 90/10, H10W 70/685, H10W 90/22

(54) **INTEGRATED CIRCUIT PACKAGE WITH DOUBLE-SIDED SIGNAL ROUTING STRUCTURE**

(30) Priority: 18.12.2024 US 202418986278
(71) Applicant: NXP USA, Inc., Austin, TX 78735 (US)
(72) Inventor: Gong, Zhiwei, 5656AG Eindhoven (NL); Hayes, Scott M, 5656AG Eindhoven (NL); Vincent, Michael B, 5656AG Eindhoven (NL)
(74) Representative: Colaiuda, Antonella

(57) **Abstract**

A system and method provides a substrate having a first surface and a second surface. A first plurality of contact pads are formed on the first surface of the substrate. A first redistribution layer is formed over the first surface of the substrate by mounting a plurality of metal balls to contact pads of the first plurality of contact pads on the first surface of the substrate, wherein the plurality of metal balls include copper, forming a layer of encapsulant surrounding at least a portion of the plurality of metal balls, depositing a dielectric layer over the plurality of metal balls and the encapsulant, and forming a second plurality of contact pads over the dielectric layer, wherein each contact pad of the second plurality of contact pads is connected through openings in the dielectric layer to metal balls of the plurality of metal balls.

## Description

### FIELD

The present invention relates generally to electronic devices and, more particularly, to packaged electronic devices and methods of assembling packaged electronic devices.

### BACKGROUND

It is often useful to combine multiple microelectronic devices, such as semiconductor die carrying integrated circuits (ICs), microelectromechanical systems (MEMS), optical devices, passive electronic components, and the like, into a single package that is both compact and structurally robust. Packaging of microelectronic devices has traditionally been carried-out using a so-called two dimensional (2D) or non-stacked approach in which two or more microelectronic devices are positioned and interconnected in a side-by-side or laterally adjacent spatial relationship. More particularly, in the case of ICs formed on semiconductor die (IC die), packaging has commonly entailed the mounting of multiple IC dies to a package substrate and the formation of desired electrical connections through wire bonding or flip-chip (FC) connections. The 2D microelectronic package may then later be incorporated into a larger electronic system by mounting the package substrate to a printed circuit board (PCB) or other component included within the electronic system.

As an alternative to 2D packaging technologies of the type described above, three dimensional (3D) packaging technologies have recently been developed in which microelectronic devices are disposed in a stacked arrangement and vertically interconnected to produce a stacked, 3D microelectronic package. Such 3D packaging techniques yield highly compact microelectronic packages well-suited for usage within mobile phones, digital cameras, digital music players, and other compact electronic devices. Additionally, 3D packaging techniques enhance device performance by reducing interconnection length, and thus signal delay, between the packaged microelectronic devices.

Fan-out Wafer Level Packaging (FOWLP) packaging, for example, uses build-up processes for package interconnections. For example, a standard RCP (Redistributed Chip Package) flow attaches an IC die to a wafer-level substrate so that a build-up interconnect layer can be formed at the active side of the IC die to provide external interconnects. These structures, however, can be difficult to implement resulting in higher costs of manufacturing.

### SUMMARY

This Summary section is neither intended to be, nor should be, construed as being representative of the full extent and scope of the this disclosure. Additional benefits, features and embodiments of the this disclosure are set forth in the attached figures and in the description hereinbelow, and as described by the claims. Accordingly, it should be understood that this Summary section may not contain all of the aspects and embodiments claimed herein.

Additionally, the disclosure herein is not meant to be limiting or restrictive in any manner. Moreover, the this disclosure is intended to provide an understanding to those of ordinary skill in the art of one or more representative embodiments supporting the claims. Thus, it is important that the claims be regarded as having a scope including constructions of various features of the this disclosure insofar as they do not depart from the scope of the methods and apparatuses consistent with the this disclosure (including the originally filed claims). Moreover, the this disclosure is intended to encompass and include obvious improvements and modifications of the this disclosure.

In some aspects, the techniques described herein relate to a semiconductor package, including: a substrate having a first surface and a second surface opposed the first surface, wherein the substrate includes a first plurality of contact pads; and a first redistribution layer over the first surface of the substrate, wherein the first redistribution layer includes: a plurality of metal balls mounted to contact pads of the first plurality of contact pads on the first surface of the substrate, wherein a melting temperature of the plurality of metal balls is at least 260 degrees Celsius, a layer of encapsulant surrounding at least a portion of the plurality of metal balls, a dielectric layer over the plurality of metal balls and the encapsulant, and a second plurality of contact pads over the dielectric layer, wherein each contact pad of the second plurality of contact pads is connected through openings in the dielectric layer to metal balls of the plurality of metal balls.

In some aspects, the techniques described herein relate to a semiconductor package, including: a substrate having a first surface and a second surface; and a first redistribution layer over the first surface of the substrate, wherein the first redistribution layer includes: a plurality of metal balls mounted to contact pads of a first plurality of contact pads on the first surface of the substrate, a layer of encapsulant surrounding at least a portion of the plurality of metal balls, a dielectric layer over the plurality of metal balls and the encapsulant, and a second plurality of contact pads over the dielectric layer, wherein each contact pad of the second plurality of contact pads is connected through openings in the dielectric layer to metal balls of the plurality of metal balls.

In some aspects, the techniques described herein relate to a method, including: providing a substrate having a first surface and a second surface; forming a first plurality of contact pads on the first surface of the substrate; and forming a first redistribution layer over the first surface of the substrate, by: mounting a plurality of metal balls to contact pads of the first plurality of contact pads on the first surface of the substrate, wherein the plurality of metal balls include copper, forming a layer of encapsulant surrounding at least a portion of the plurality of metal balls, depositing a dielectric layer over the plurality of metal balls and the encapsulant, and forming a second plurality of contact pads over the dielectric layer, wherein each contact pad of the second plurality of contact pads is connected through openings in the dielectric layer to metal balls of the plurality of metal balls.

### BRIEF DESCRIPTION OF THE DRAWINGS

The accompanying drawings, which are included to provide a further understanding of the invention and are incorporated in and constitute a part of this specification, illustrate embodiments of the invention and together with the description serve to explain the principles of the invention.

In the drawings:
FIG. 1 depicts a conventional semiconductor package 100.
FIGS. 2 - 11 depict steps in a manufacturing process of the present IC package or device design.
FIG. 12 is a flowchart depicting a method of manufacturing an IC package in accordance with the this disclosure.
FIG. 13 illustrates another embodiment of an IC package device configured in accordance with the this disclosure.
FIG. 14 illustrates yet another embodiment of an IC package device configured in accordance with the this disclosure.

### DETAILED DESCRIPTION OF THE ILLUSTRATED EMBODIMENTS

The present invention relates generally to electronic devices and, more particularly, to packaged electronic devices and methods of assembling packaged electronic devices.

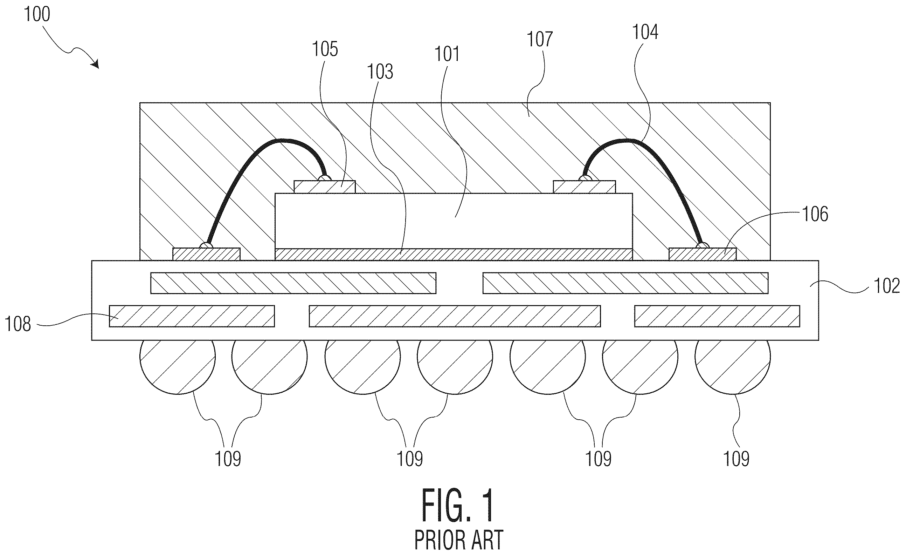

FIG. 1 depicts a conventional semiconductor package 100. Package 100 includes substrate 102 upon which semiconductor die 101 is mounted via interposer 103. Die 101 includes bond pads 105 that provide access to electrical circuits therewithin. Substrate 102 has several patterned conductive features, including redistribution (RDL) layer 108 and bond sites 106. Wire bonds 104 extend between bond pads 105 and bond sites 106 to allow semiconductor die 101 to receive power from, and communicate signals to and from, its external environment. After redistribution by RDL layer 108, bond pads 105 of semiconductor die 101 are electrically accessible via corresponding solder bumps 109. Die 101 and wire bonds 104 are encapsulated by mold compound 107.

Generally, the manufacturing of conventional semiconductor package 100 takes place by attaching die 101 to the top or first surface of substrate 102, fabricating wire bonds 104 between die 101 and substrate 102, encapsulating the assembly with mold compound 107, and fabricating solder bumps 109 on the bottom surface (i.e., a second surface opposite the first or top surface) of substrate 102.

As depicted by FIG. 1, conventional semiconductor package 100 is configured in a single-sided routing configuration in which electrical signals are supplied or received from the package through corresponding solder bumps 109 disposed on a single side of conventional semiconductor package 100.

In more complex electronic devices, to achieve the desired number of input/output connections for a relatively small package size, it may be necessary to provide input/output terminals and corresponding electrical signal routing networks on multiple sides of the semiconductor package.

For example, double sided routing approaches may be utilized by high-density system-in-package (SIP) module packaging applications to enable adequate numbers of electrical signal interconnects while also allowing for good electrical, thermal and reliability performance. Double sided routing is often achieved with advanced packaging technologies, such as fan-out wafer-level packaging (FOWLP), panel level packaging (PLP), integrated fan-out (InFO) packaging, etc., which enable desired package structures and signal routing capabilities. However, it is well known that these approaches can have disadvantages including high cost and complexity, which may lead to increased product lead times and, potentially, reduced package reliability.

Consequently, it can be desirable to provide an approach for IC package design that enables double sided routing capability to allow for the manufacture of high-density SIP packages, for example, with reduced cost and complexity.

In the this disclosure, therefore, a novel approach for IC package design is provided in which copper or other metal balls are mounted to the package substrate during fabrication to facilitate later formation of conductive signal routing structures in the package. For example, the copper or other metal balls may be utilized to fill gaps caused by placement of the various "basement level die" within a larger desired package footprint. Specifically, after the copper (or other metal) balls are attached to the substrate (e.g., in the same step as the mounting of package flip-chip (FC) die), an over-mold material that is disposed over and around the metal balls is ground down (or otherwise thinned) to expose the metal balls. Typically, this will involve, as described below, some grinding of the outer portion of the metal balls to generate a small flat or planar component mounting surface at which material of the metal balls is exposed to form set of metal contact pads that are co-planar with the mounting surface. Routing layers can then be formed over and connected to those flat surfaces as a second routing structure in addition to the package substrate itself. In a final step, solder balls (e.g., in a ball-grid array (BGA) configuration) can be mounted to the routing layers enabling external component connections.

The use of copper balls in this manner (as opposed to just reusing solder balls) prevents deformation of the balls during the IC package fabrication process, such as during solder reflow processing, because the melting temperature of the copper or metal balls is significantly higher than the solder reflow process. In typical applications, for example, the melting point of copper and typical copper alloys (e.g. Copper (Cu) 194, Cu 1025) used for semiconductor packaging is slightly higher than 1000 Celsius ^{©}. The typical lead-free solder alloys used for packaging (e.g., SAC305) has a melting point of about 218 C. The peak temperature of reflow processes are usually about 260 C.

However, simplicity of fabrication is maintained because the copper or other metal balls can be deposited onto the package using conventional ball placement technologies. As such, the copper (or other metal) balls are more resilient than solder balls used during the fabrication of other IC chip packages and provided added strength and rigidity to the overall package. The copper or other metal balls, in addition to increasing the structural integrity of the package are easy to place and provide conductive interconnect structures within the package that are easy to interconnect with other conductive structures or components within the package.

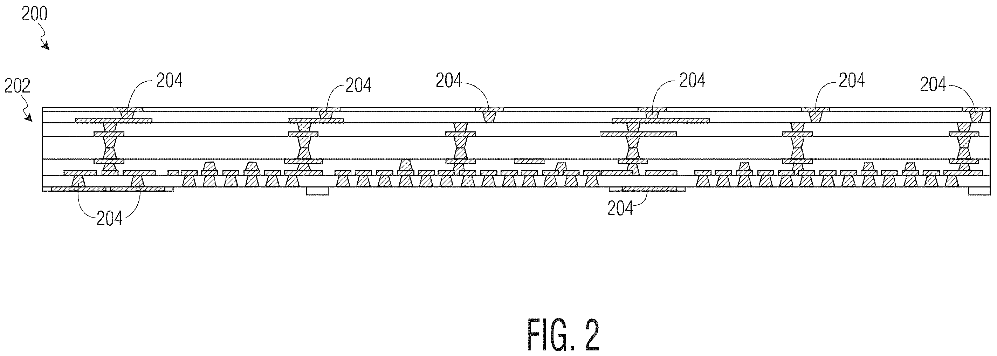

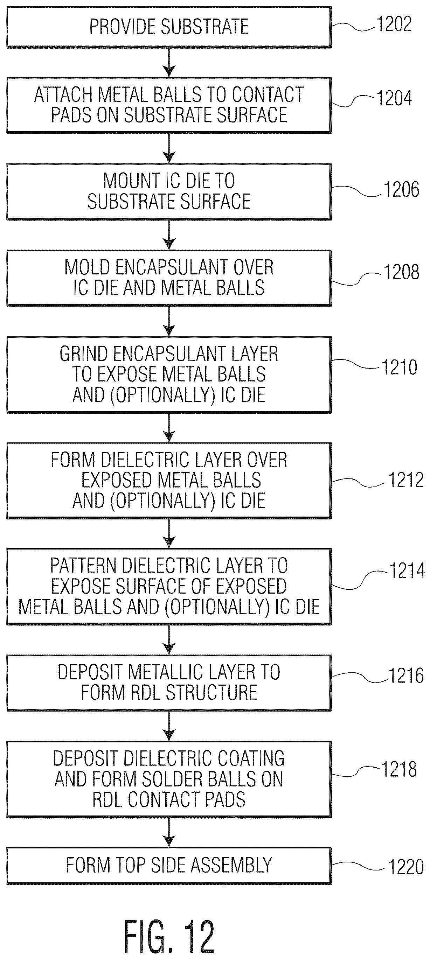

To illustrate, FIGS. 2 - 11 depicts steps in a manufacturing process for an IC package 200 configured in accordance with the this disclosure. FIG. 12 is a flowchart depicting a method of manufacturing an IC package in accordance with the this disclosure. FIGS. 2 - 11 therefore depicts steps in the method of FIG. 12. FIGS. 2 - 11 and FIG. 12 will now be described in conjunction.

As illustrated in FIG. 2, in an initial step 1202 (FIG. 12), a substrate 202 is provided. As illustrated, substrate 202 may be a multi-layered printed circuit board (PCB) comprising multiple laminated layers of non-conductive material and a conductive signal routing network formed between and through the layers in the substrate 202 (e.g., comprising conductive traces formed on a surface of a layer in the substrate 202 and conductive vias formed through layers in the substrate 202). Alternatively, substrate 202 may be a single-layer substrate, such as a single layer PCB.

Substrate 202 includes contact pads 204 formed over outer surfaces of substrate 202 and which represent electrical connection points for components that are external to substrate 202. As illustrated, contact pads 204 may be formed over the top or bottom (as viewed in FIG. 2) surfaces of substrate 202.

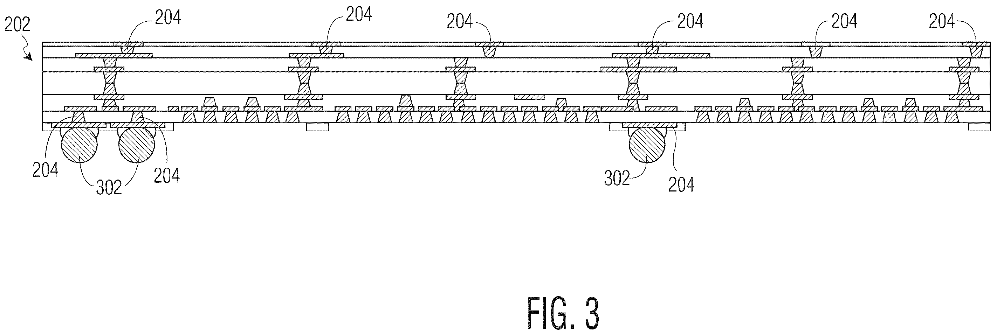

Referring to FIG. 3, in step 1204 (FIG. 12), metal balls 302 are attached to contact pads 204 of substrate 202. Metal balls 302 may comprises any conductive metal that has a melting temperature greater than that of a solder material, such as the solder material making up solder balls 1002 which will subsequently form external contacts of package 200 such as the solder balls, described below. In an embodiment, metal balls 302 do not include any coating or treatment with materials (e.g., solders) that exhibit lower melting temperatures than metal balls 302. This characteristic of metal balls 302 means that once the metal balls 302 are installed into package 200 mid-way through the fabrication processes, later exposure to the high temperatures associated with later-implemented solder reflow processes will not cause metal balls 302 to deform or change shape. Example materials for metal balls 302 may include copper, copper alloys, nickel, gold, silver, and the like. Metal balls 302 can be attached to substrate using any suitable attachment approach, such as using electrically conductive adhesives and/or solder paste. In that case, solder paste application can be done using stencil printing, screen printing, pin transfer, dispensing, etc. Ball 302 placement is usually done thru a stencil patterned with an opening over pad 204. After the balls are placed over the paste, the solder paste will hold the ball 302 in place above pad 204 thru reflow to solder the ball down to the pad 204. When solder paste is used for ball 302 attachment, the volume of paste can be controlled to limit the wetting of the solder paste up the outer surface of the metallic ball 302. In such an embodiment, it may be that the amount of solder paste is selected so that no solder wets significantly past the midline/waist of the ball 302.

Metal balls 302 can be deposited using any suitable package fabrication procedure, as described above, that involves mount ball-shaped objects to a substrate. As such, metal balls 302, although provide a novel function within package 200 (described in more detail below) can be deposited using conventional fabrication processes, which simplifies the process for fabricating package 200.

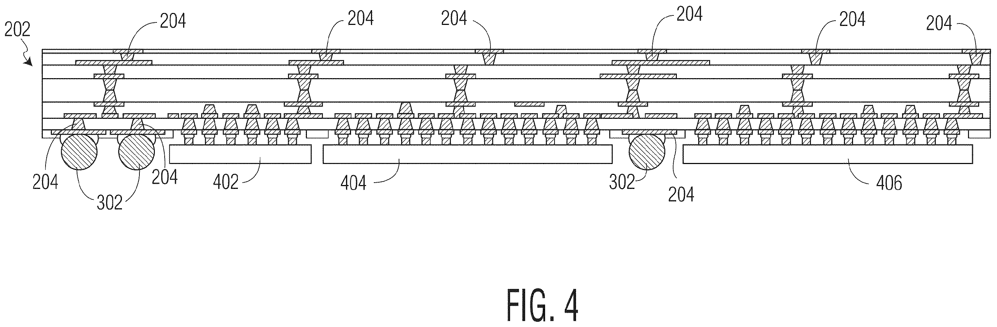

Referring to FIG. 4, in step 1206 (FIG. 12), one or more IC dies 402, 404, and 406 may be mounted to substrate 202. In one or more embodiment, this can involve FC-mounting IC dies 402, 404, and 406 to substrate 202 in regions between metal balls 302 to appropriately-arrange contact pads on a surface of substrate 202. Although FC mounting is depicted in FIG. 4, it should be understood that IC dies 402, 404, and 406 could be mounted to substrate 202 using any suitable IC-mounting approach. For example, dies 402, 404, and 406 could be attached with bonding material and electrical connections between the die to the substrate being made with bonding wires. Additionally, although IC dies 402, 404, and 406 are depicted, it should be understood that the package being fabricated could include any number of IC dies that could be mounted to any surface of substrate 202. In fact, the present approach for package manufacturing may be utilized to construct packages that do not include individual IC dies and instead are used to generate packages comprising other types of components (e.g., networks of passive devices or simple components) that utilize the present approach for manufacturing a package incorporating a double-sided routing network in accordance with the this disclosure.

In various embodiments, each of IC dies 402, 404, and 406 may be singulated from a semiconductor wafer, which can be any semiconductor material or combinations of materials, such as gallium arsenide, silicon germanium, silicon-on-insulator (SOI), silicon, monocrystalline silicon, the like, and combinations of the above. Such a semiconductor die typically includes active circuitry, which may include IC components that are active when the die is powered.

When IC dies 402, 404, and 406 are fabricated, active circuitry is formed on a semiconductor wafer using several processes including depositing semiconductor materials including dielectric materials and metals, such as growing, oxidizing, sputtering, and conformal depositing, etching semiconductor materials, such as using a wet etchant or a dry etchant, planarizing semiconductor materials, such as performing chemical mechanical polishing or planarization, performing photolithography for patterning, including depositing and removing photolithography masks or other photoresist materials, ion implantation, annealing, and the like.

In some embodiments, the active circuitry of a die may be a combination of IC components or may be another type of microelectronic device. Examples of IC components include but are not limited to a processor, memory, logic, oscillator, analog circuitry, sensor, microelectromechanical systems (MEMS) device, a standalone discrete device such as a resistor, inductor, capacitor, diode, power transistor, and the like.

Although FIG. 3 and FIG. 4, in combination with steps 1204 and 1206 (FIG. 12) indicate that metal balls 302 are placed before IC dies 402, 404, 406, it should be understood that these steps could easily be reversed such that the metal balls 302 are placed after IC dies 402, 404, 406. Furthermore, metal balls 302 may, in some cases, be placed at the same time as IC dies 402, 404, 406 in a single manufacturing step.

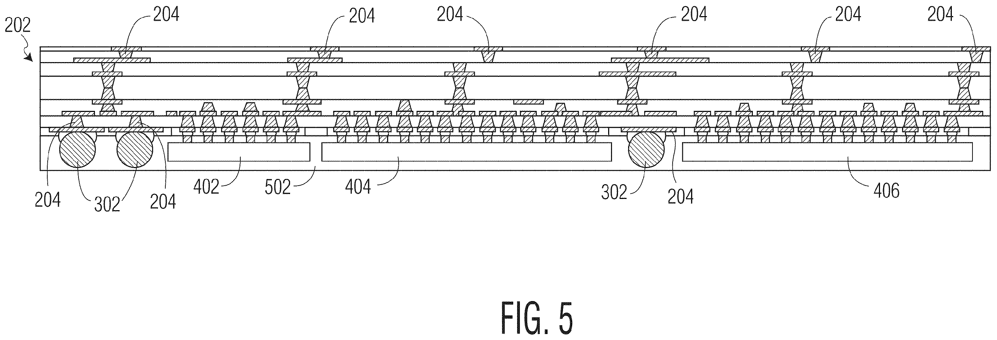

With metal balls 302 and IC dies 402, 404, 406 placed, as shown in FIG. 5, in step 1208 (FIG. 12) an encapsulant material 502 is molded over and around metal balls 302 and IC dies 402, 404, 406. The encapsulant material may include epoxy resin molding compounds that can include epoxy resins, phenolic hardeners, silicas, catalysts, pigments, and mold release agents to fine-tune properties of the encapsulant. Because metal balls 302 are spherical, encapsulant material 502 flows around the entirety of metal balls 302 (other than the small region that is mounted to substrate 202). This comprehensive coverage strengthens the connections between metal balls 302 and encapsulant material 502, providing added rigidity and robustness to the final package 200.

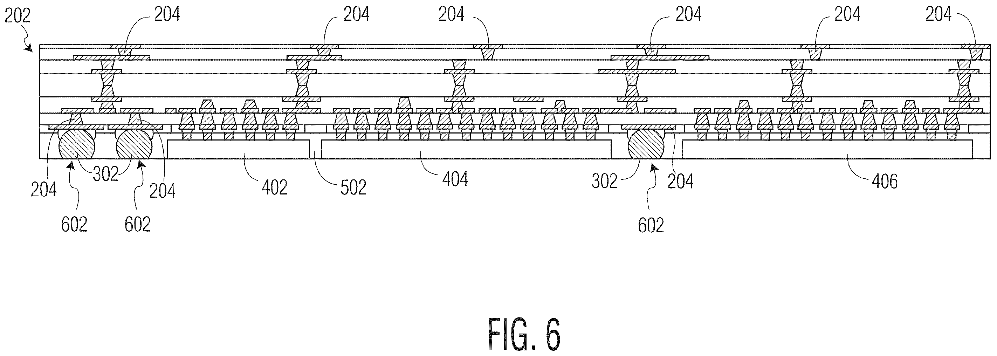

As shown in FIG. 6, at step 1210 (FIG. 12) a back-etching or other thinning processes (e.g., strip grinding) is applied to batch-etch the encapsulant material 502 that was deposited in step 1208 to expose at least a portion of metal balls 302. This step generally involves performing the back-etching until the encapsulant has been removed to expose a portion of the bottom surface of metal balls 302 and, further, to etch or grind flat surfaces 602 on the outer surface metal balls 302. The process is controlled, however, so as to not expose any solder materials that was used to adhere the metal balls 302 to their respective contact pads 204, thereby reducing the likelihood of solder extrusions in the final package. This process may involve, optionally, griding encapsulant material 502 such that the back surface of one or more IC dies 402, 404, 406 is exposed as part of the grinding process.

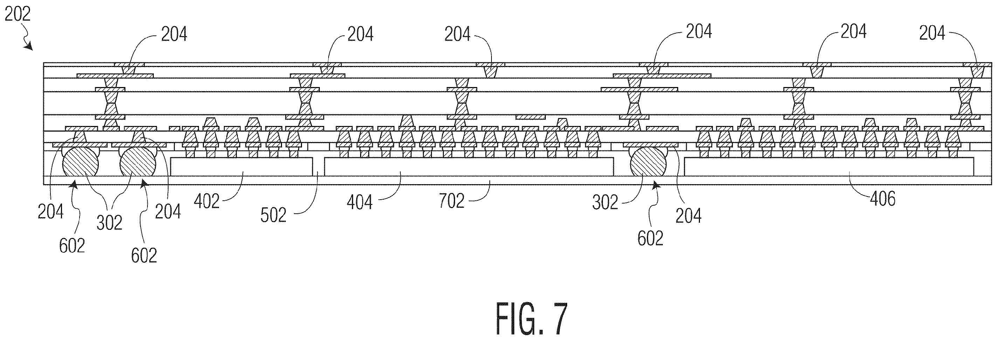

As illustrated in FIG. 7, at step 1212 (FIG. 12) dielectric layer 702 is formed on the planarized backside surface formed by the grinding or back-etching process of step 1210 described above.

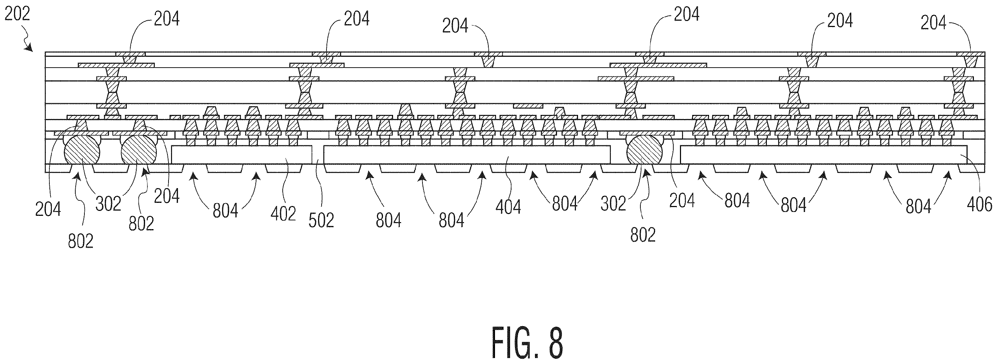

As illustrated in FIG. 8, dielectric layer 702 is then etched (e.g., via lithography, laser ablation, dry etching, etc.) in step 1214 to expose the conductive flat surfaces 602 of metal balls 302 via openings 802. If solder is exposed during this process, via openings 802 are designed such that openings 802 are inset of any solder 'ring' around the perimeter of the exposed metal balls 302.This etching process may also create openings 804 that expose electric interconnects (e.g., contact pads) on the surface of any of IC dies 402, 404, 406 that were optionally exposed during the etching or back grinding process of step 1210. In one or more embodiment, for example, one or more die 402, 404, 406 is oriented with its active side "face down". The die pads can be exposed by step 1210. As the etching/grinding will partially remove the pad material, the pad needs to have a thickness that would not be completely removed by step 1210, e.g. the thick Cu pad (10-30 um) or Cu pillar (10-100 um) can be included. Alternatively, the electrical contact with dies 402, 404, and 406 can also be made to the "back side" of die when the back side of the die is conductive, e.g., a MOSFET. In one or more other embodiment, openings 804 can also be made on the backside of die surface without electrical connection. The solder balls 1002 will serve as thermal structure to conduct the heat from the die to PCB, also serve as mechanical reinforcement structure to improve robustness on the board, e.g., prove BLR (board level reliability).

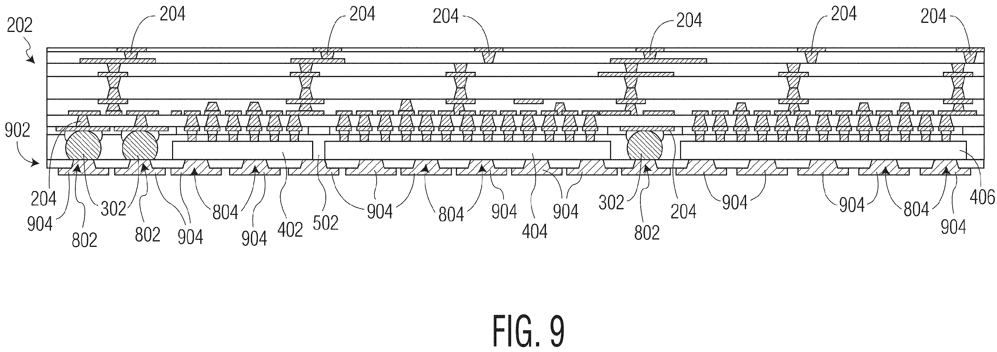

As illustrated in FIG. 9, in step 1216 metal layer 902 is deposited (e.g., via lithography, conductive paste printing, direct deposition, etc.) and patterned to form conductive structures over each of the openings 802 and openings 804 formed in step 1214. Metal layer 902 forms a plurality of conductive structures 904 that make up an RDL layer on the bottom surface of substrate 202. Optionally, an additional dielectric layer can be deposited and patterned over metal layer 902 to define solder pad openings over conductive structures 904 (e.g., contact pads).

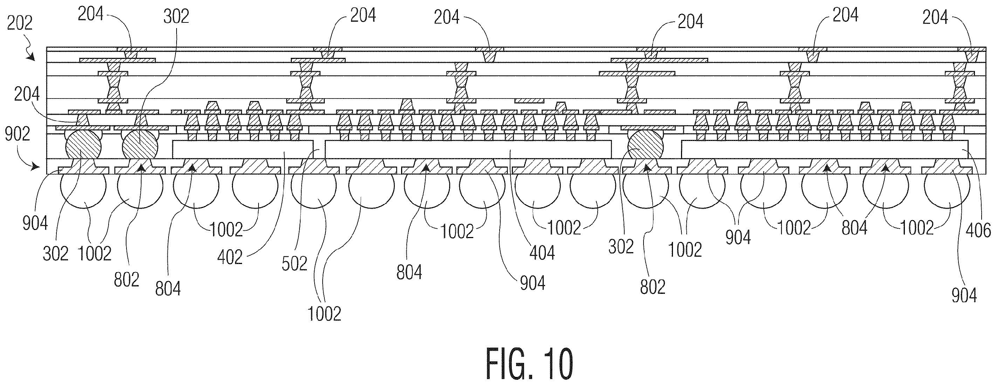

As illustrated in FIG. 10, in step 1218 solder is deposited on each conductive structure 904 to form solder balls 1002. Solder balls 1002 enable package 200 to be mounted to other system components in, for example, a ball grid array (BGA) configuration via a solder reflow process.

With the package as shown in FIG. 10, package 200 can be incorporated into larger systems. Addition components may also be attached to package 200 on the side opposing solder balls 1002. In the BGA configuration, package 200 can be mounted to an external component where solder balls 1002 are first placed in physical contact with contact pads on the external component. The solder balls 1002 are then exposed to ambient temperatures sufficient to at least partially melt solder balls 1002 to cause them to adhere to the contact pads. As discussed above, the ambient temperatures in this solder reflow process are too low to cause any softening in metal balls 302 so that structural rigidity provided by metal balls 302 to package 200 is maintained, even after a solder reflow process.

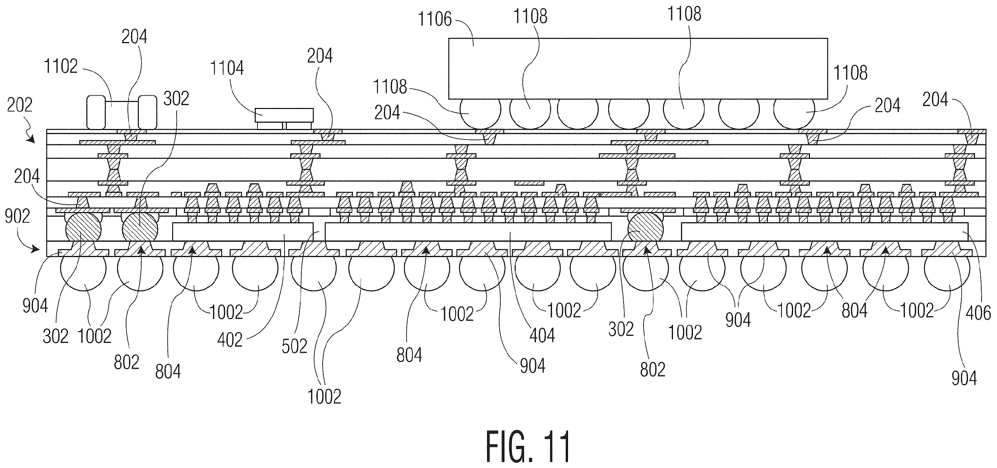

As illustrated in FIG. 11, therefore, and in an optional step 1220 (FIG. 12), a top side assembly may be formed on package 200. In this example, the top side assembly includes surface mount components 1102 and 1104, which could include passive or active components, or, in some cases ICs. IC die 1106 is mounted to electrical interconnects on a top surface of substrate 202 via solder balls 1108.

In the configuration of package 200 as illustrated in FIG. 11, therefore, dual-side electrical interconnects are formed on package 200. External connections on a bottom side of package 200 are formed then an RDL layer that include metal balls which are deposited mid-way through the fabrication process of the RDL layer. Top surface interconnects can be formed through any appropriate means including, as illustrated, surface mount and FC mounting.

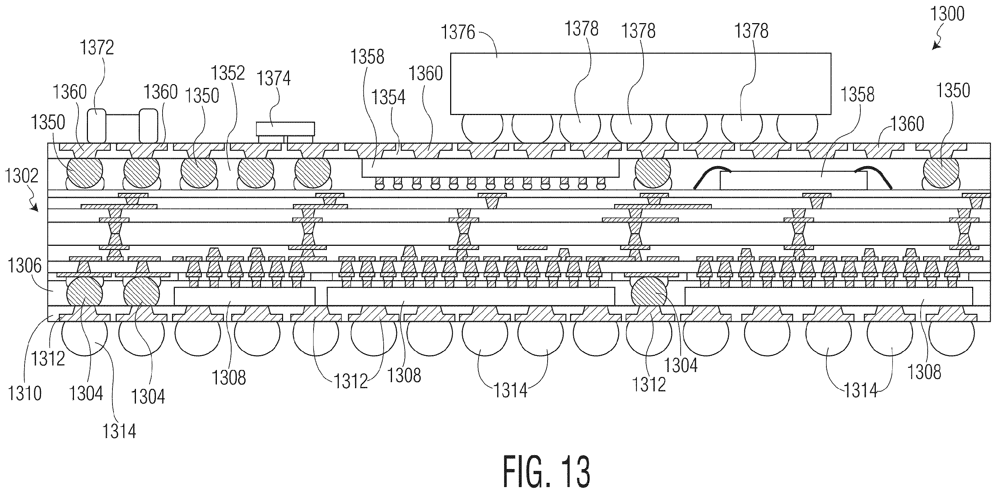

FIG. 13 illustrates an IC package device 1300 configured in accordance with the this disclosure. Device 1300 includes a substrate 1302, which is configured similarly to substrate 202 of FIGS. 2-11. On a bottom side of substrate 1302 an RDL structure is formed (e.g., in accordance with the method of FIG. 12) enabling external components to be electrically connected to device 1300. Specifically, the RDL structure includes metal balls 1304 (e.g., metal balls 302) that are mounted to contact pads on the bottom surface of substrate 1302. Metal balls 1304 may comprises any conductive metal that has a melting temperature greater than that of a solder material, such as the solder material making up solder balls 1314, described below. This characteristic of metal balls 1304 means that once the metal balls 1304 are installed into device 1300 mid-way through the fabrication processes, later exposure to the high temperatures associated with later-implemented solder reflow processes will not cause metal balls 1304 to deform or change shape. Example materials for metal balls 1304 may include copper, copper alloys, nickel, gold, silver, and the like.

An encapsulant 1306 is flowed over and around metal balls 1304 as well as any IC dies 1308 that are mounted to the bottom surface of substrate 1302. The encapsulant, once molded, is ground down to expose surface portions of metal balls 1304. And, in one or more embodiment, the grinding is continued so as to grind flat spots on metal balls 1304. Dielectric layer 1310 is deposited over encapsulant 1306 and metal balls 1304. Dielectric layer 1310 is etched to expose the surface of metal balls 1304 (and any contact pads of dies 1308 - depending on how electrical interconnects are to be formed to dies 1308, if any). A metal layer is patterned over dielectric layer 1310 to form conductive pads 1312 over each of the openings in dielectric layer 1310 and in physical contact with metal balls 1304. Solder balls 1314 are mounted to conductive pads 1312 to complete the RDL structure.

On the top surface of substrate 1302, metal balls 1350 (e.g., comprising the same material as metal balls 1304) are mounted to substrate 1302. In the same manner as the bottom surface of device 1300, an RDL structure formed on the top side of device 1300 using metal balls 1350. Specifically, encapsulant 1352 is formed over metal balls 1350 and then ground to expose at least a portion of metal balls 1350 and, optionally, grind a flat surface into metal balls 1350. Dielectric layer 1354 is deposited and patterned to expose the flat surfaces of metal balls 1350 and, optionally, contact pads of dies 1358. A metal layer is patterned over dielectric layer to create contact pad structures 1360. The RDL structure is thus completed enabling external system components arranged in a top side assembly to be mounted to device 1300. In this example, the top side assembly includes surface mount components 1372 and 1374 mounted to contact pad structures 1360, which could include passive or active components, or, in some cases ICs. IC die 1376 is mounted to contact pad structures 1360 via solder balls 1378.

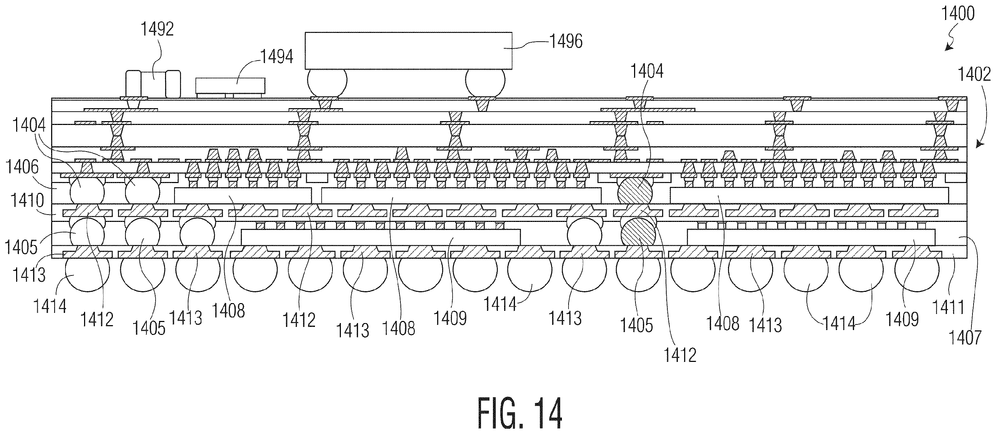

FIG. 14 illustrates an IC package device 1400 configured in accordance with the this disclosure. Device 1400 includes a substrate 1402, which is configured similarly to substrate 202 of FIGS. 2-11. On a bottom side of substrate 1402 an RDL structure is formed enabling external components to be electrically connected to device 1400.

Specifically, the RDL structure includes metal balls 1404 (e.g., metal balls 302) that are mounted to contact pads on the bottom surface of substrate 1402. Metal balls 1404 may comprises any conductive metal that has a melting temperature greater than that of a solder material, such as the solder material making up solder balls 1414, described below. This characteristic of metal balls 1404 means that once the metal balls 1404 are installed into device1400 mid-way through the fabrication processes, later exposure to the high temperatures associated with later-implemented solder reflow processes will not cause metal balls 1404 to deform or change shape. Example materials for metal balls 1404 may include copper, copper alloys, nickel, gold, silver, and the like.

An encapsulant 1406 is flowed over and around metal balls 1404 as well as any IC dies 1408 that are mounted to the bottom surface of substrate 1402. The encapsulant, once molded, is ground down to expose surface portions of metal balls 1404. And, in one or more embodiment, the grinding is continued so as to grind flat spots on metal balls 1404. Dielectric layer 1410 is deposited over encapsulant 1406 and metal balls 1404. Dielectric layer 1410 is etched to expose the surface of metal balls 1404 (and any contact pads of dies 1408 - depending on how electrical interconnects are to be formed to dies 1408, if any). A metal layer is patterned over dielectric layer 1410 to form conductive pads 1412 over each of the openings in dielectric layer 1410 and in physical contact with metal balls 1404.

The RDL structure further includes additional metal balls 1405 (e.g., metal balls 302) that are mounted to contact pads 1412. Metal balls 1405 may comprises any conductive metal that has a melting temperature greater than that of a solder material, such as the solder material making up solder balls 1414, described below. This characteristic of metal balls 1405 means that once the metal balls 1405 are installed into device 1400 mid-way through the fabrication processes, later exposure to the high temperatures associated with later-implemented solder reflow processes will not cause metal balls 1405 to deform or change shape. Example materials for metal balls 1405 may include copper, copper alloys, nickel, gold, silver, and the like.

An encapsulant 1407 is flowed over and around metal balls 1405 as well as any IC dies 1409 that are mounted to the bottom surface of dielectric layer 1410. The encapsulant, once molded, is ground down to expose surface portions of metal balls 1405. And, in one or more embodiment, the grinding is continued so as to grind flat spots on metal balls 1405. Dielectric layer 1411 is deposited over encapsulant 1407 and metal balls 1405. Dielectric layer 1411 is etched to expose the surface of metal balls 1404 (and any contact pads of dies 1409 - depending on how electrical interconnects are to be formed to dies 1308, if any). A metal layer is patterned over dielectric layer 1411 to form conductive pads 1413 over each of the openings in dielectric layer 1411 and in physical contact with metal balls 1405. Solder balls 1414 are mounted to conductive pads 1413 to complete the RDL structure.

A top side assembly may be formed in device 1400 on a top surface of substrate 1402. In this example, the top side assembly includes surface mount components 1492 and 1494, which could include passive or active components, or, in some cases ICs. IC die 1496 is mounted to electrical interconnects on a top surface of substrate 1402 via solder balls.

In some aspects, the techniques described herein relate to a semiconductor package, including: a substrate having a first surface and a second surface opposed the first surface, wherein the substrate includes a first plurality of contact pads; and a first redistribution layer over the first surface of the substrate, wherein the first redistribution layer includes: a plurality of metal balls mounted to contact pads of the first plurality of contact pads on the first surface of the substrate, wherein a melting temperature of the plurality of metal balls is at least 260 degrees Celsius, a layer of encapsulant surrounding at least a portion of the plurality of metal balls, a dielectric layer over the plurality of metal balls and the encapsulant, and a second plurality of contact pads over the dielectric layer, wherein each contact pad of the second plurality of contact pads is connected through openings in the dielectric layer to metal balls of the plurality of metal balls.

In some aspects, the techniques described herein relate to a semiconductor package, further including an integrated circuit die mounted to the first surface of the substrate, and wherein the integrated circuit die is electrically connected to contact pads of the first plurality of contact pads.

In some aspects, the techniques described herein relate to a semiconductor package, wherein the encapsulant is at least partially disposed around the integrated circuit die.

In some aspects, the techniques described herein relate to a semiconductor package, wherein the integrated circuit die includes a passive electrical device.

In some aspects, the techniques described herein relate to a semiconductor package, wherein at least at least a portion of an outer surface of a first metal ball of the plurality of metal balls includes a planar surface.

In some aspects, the techniques described herein relate to a semiconductor package, wherein a first contact pad of the second plurality of contact pads is directly connected to the planar surface of the first metal ball.

In some aspects, the techniques described herein relate to a semiconductor package, further including a second redistribution layer over the second surface of the substrate opposite the first redistribution layer, wherein the second redistribution layer includes a second a plurality of metal balls mounted to a third plurality of contact pads on the second surface of the substrate.

In some aspects, the techniques described herein relate to a semiconductor package, further including a plurality of solder balls mounted to the second plurality of contact pads.

In some aspects, the techniques described herein relate to a semiconductor package, wherein the plurality of metal balls include copper or copper alloys.

In some aspects, the techniques described herein relate to a semiconductor package, including: a substrate having a first surface and a second surface; and a first redistribution layer over the first surface of the substrate, wherein the first redistribution layer includes: a plurality of metal balls mounted to contact pads of a first plurality of contact pads on the first surface of the substrate, a layer of encapsulant surrounding at least a portion of the plurality of metal balls, a dielectric layer over the plurality of metal balls and the encapsulant, and a second plurality of contact pads over the dielectric layer, wherein each contact pad of the second plurality of contact pads is connected through openings in the dielectric layer to metal balls of the plurality of metal balls.

In some aspects, the techniques described herein relate to a semiconductor package, further including an integrated circuit die mounted to the first surface of the substrate, and wherein the integrated circuit die is electrically connected to contact pads of the first plurality of contact pads.

In some aspects, the techniques described herein relate to a semiconductor package, wherein the encapsulant is at least partially disposed around the integrated circuit die.

In some aspects, the techniques described herein relate to a semiconductor package, wherein at least at least a portion of an outer surface of a first metal ball of the plurality of metal balls includes a planar surface that is coplanar with a surface of the integrated circuit die.

In some aspects, the techniques described herein relate to a semiconductor package, wherein a first contact pad of the second plurality of contact pads is directly connected to the planar surface of the first metal ball.

In some aspects, the techniques described herein relate to a semiconductor package, further including a plurality of solder balls mounted to the second plurality of contact pads.

In some aspects, the techniques described herein relate to a semiconductor package, wherein a melting temperature of the plurality of metal balls is greater than a melting temperature of the plurality of solder balls.

In some aspects, the techniques described herein relate to a method, including: providing a substrate having a first surface and a second surface; forming a first plurality of contact pads on the first surface of the substrate; and forming a first redistribution layer over the first surface of the substrate, by: mounting a plurality of metal balls to contact pads of the first plurality of contact pads on the first surface of the substrate, wherein the plurality of metal balls include copper, forming a layer of encapsulant surrounding at least a portion of the plurality of metal balls, depositing a dielectric layer over the plurality of metal balls and the encapsulant, and forming a second plurality of contact pads over the dielectric layer, wherein each contact pad of the second plurality of contact pads is connected through openings in the dielectric layer to metal balls of the plurality of metal balls.

In some aspects, the techniques described herein relate to a method, further including mounting an integrated circuit die mounted to the first surface of the substrate to electrically connect the integrated circuit die to contact pads of the first plurality of contact pads.

In some aspects, the techniques described herein relate to a method, wherein depositing the encapsulant includes depositing the encapsulant at least partially around the integrated circuit die.

In some aspects, the techniques described herein relate to a method, further including forming a second redistribution layer over the second surface of the substrate opposite the first redistribution layer, wherein the second redistribution layer includes a second a plurality of metal balls mounted to a third plurality of contact pads on the second surface of the substrate.

In the foregoing specification, the invention has been described with reference to specific examples of embodiments of the invention. It will, however, be evident that various modifications and changes may be made therein without departing from the broader scope of the invention as set forth in the appended claims, and that the claims are not limited to the specific examples described.

Some of the above embodiments, as applicable, may be implemented using a variety of different circuitry components. For example, the exemplary topology in the Figures and the discussion thereof is presented merely to provide a useful reference in discussing various aspects of the invention. Of course, the description of the topology has been simplified for purposes of discussion, and it is just one of many different types of appropriate topologies that may be used in accordance with the invention. Thus, for example, it will be appreciated that the various die illustrated herein can have varying thicknesses.

Skilled artisans will appreciate that elements in the Figures are illustrated for simplicity and clarity and have not necessarily drawn to scale. For example, the chosen elements are only used to help to improve the understanding of the functionality and the arrangements of these elements in various embodiments of the present invention. Also, common but well understood elements that are useful or necessary in a commercial feasible embodiment are mostly not depicted in order to facilitate a less abstracted view of these various embodiments of the present invention. It will further be appreciated that certain actions and/or steps in the described method may be described or depicted in a particular order of occurrences while those skilled in the art will understand that such specificity with respect to sequence is not actually required. It will also be understood that the terms and expressions used in the present specification have the ordinary meaning as it accorded to such terms and expressions with respect to their corresponding respective areas of inquiry and study except where specific meanings have otherwise be set forth herein.

As used herein, the word "exemplary" means "serving as an example, instance, or illustration." Any implementation described herein as exemplary is not necessarily to be construed as preferred or advantageous over other implementations. Furthermore, there is no intention to be bound by any expressed or implied theory presented in the preceding technical field, background, or detailed description.

The connecting lines shown in the various figures contained herein are intended to represent exemplary functional relationships and/or physical couplings between the various elements. It should be noted that many alternative or additional functional relationships or physical connections may be present in one or more embodiment of the subject matter. In addition, certain terminology may also be used herein for the purpose of reference only, and thus are not intended to be limiting, and the terms "first", "second" and other such numerical terms referring to structures do not imply a sequence or order unless clearly indicated by the context.

As used herein, a "node" means any internal or external reference point, connection point, junction, signal line, conductive element, or the like, at which a given signal, logic level, voltage, data pattern, current, or quantity is present. Furthermore, two or more nodes may be realized by one physical element (and two or more signals can be multiplexed, modulated, or otherwise distinguished even though received or output at a common node).

The foregoing description refers to elements or nodes or features being "connected" or "coupled" together. As used herein, unless expressly stated otherwise, "connected" means that one element is directly joined to (or directly communicates with) another element, and not necessarily mechanically. Likewise, unless expressly stated otherwise, "coupled" means that one element is directly or indirectly joined to (or directly or indirectly communicates with, electrically or otherwise) another element, and not necessarily mechanically. Thus, although the schematic shown in the figures depict one exemplary arrangement of elements, additional intervening elements, devices, features, or components may be present in one or more embodiment of the depicted subject matter.

While at least one exemplary embodiment has been presented in the foregoing detailed description, it should be appreciated that a vast number of variations exist. It should also be appreciated that the exemplary embodiment or embodiments described herein are not intended to limit the scope, applicability, or configuration of the claimed subject matter in any way. Rather, the foregoing detailed description will provide those skilled in the art with a convenient road map for implementing the described embodiment or embodiments. It should be understood that various changes can be made in the function and arrangement of elements without departing from the scope defined by the claims, which includes known equivalents and foreseeable equivalents at the time of filing this patent application.

## Claims

1. A semiconductor package, comprising:
a substrate having a first surface and a second surface opposed the first surface, wherein the substrate includes a first plurality of contact pads; and
a first redistribution layer over the first surface of the substrate, wherein the first redistribution layer includes:
a plurality of metal balls mounted to contact pads of the first plurality of contact pads on the first surface of the substrate, wherein a melting temperature of the plurality of metal balls is at least 260 degrees Celsius,
a layer of encapsulant surrounding at least a portion of the plurality of metal balls,
a dielectric layer over the plurality of metal balls and the encapsulant, and
a second plurality of contact pads over the dielectric layer, wherein each contact pad of the second plurality of contact pads is connected through openings in the dielectric layer to metal balls of the plurality of metal balls.

2. The semiconductor package of claim 1, further comprising an integrated circuit die mounted to the first surface of the substrate, and wherein the integrated circuit die is electrically connected to contact pads of the first plurality of contact pads.

3. The semiconductor package of claim 2, wherein the encapsulant is at least partially disposed around the integrated circuit die.

4. The semiconductor package of claim 2, wherein the integrated circuit die includes a passive electrical device.

5. The semiconductor package of any preceding claim, wherein at least at least a portion of an outer surface of a first metal ball of the plurality of metal balls includes a planar surface.

6. The semiconductor package of claim 5, wherein a first contact pad of the second plurality of contact pads is directly connected to the planar surface of the first metal ball.

7. The semiconductor package of any preceding claim, further comprising a second redistribution layer over the second surface of the substrate opposite the first redistribution layer, wherein the second redistribution layer includes a second a plurality of metal balls mounted to a third plurality of contact pads on the second surface of the substrate.

8. The semiconductor package of any preceding claim, further comprising a plurality of solder balls mounted to the second plurality of contact pads.

9. The semiconductor package of any preceding claim, wherein the plurality of metal balls include copper or copper alloys.

10. A method, comprising:
providing a substrate having a first surface and a second surface;
forming a first plurality of contact pads on the first surface of the substrate; and
forming a first redistribution layer over the first surface of the substrate, by:
mounting a plurality of metal balls to contact pads of the first plurality of contact pads on the first surface of the substrate, wherein the plurality of metal balls include copper,
forming a layer of encapsulant surrounding at least a portion of the plurality of metal balls,
depositing a dielectric layer over the plurality of metal balls and the encapsulant, and
forming a second plurality of contact pads over the dielectric layer, wherein each contact pad of the second plurality of contact pads is connected through openings in the dielectric layer to metal balls of the plurality of metal balls.

11. The method of claim 10, further comprising mounting an integrated circuit die mounted to the first surface of the substrate to electrically connect the integrated circuit die to contact pads of the first plurality of contact pads.

12. The method of claim 11, wherein depositing the encapsulant includes depositing the encapsulant at least partially around the integrated circuit die.

13. The method of any of claim 10 to claim 12, further comprising forming a second redistribution layer over the second surface of the substrate opposite the first redistribution layer, wherein the second redistribution layer includes a second a plurality of metal balls mounted to a third plurality of contact pads on the second surface of the substrate.
